Europäisches Patentamt

(19) European Patent Office

Office européen des brevets

(11) Publication number: **0 131 449**
**B1**

(12) **EUROPEAN PATENT SPECIFICATION**

(45) Date of publication of patent specification: **09.05.90**

(21) Application number: **84304632.7**

(22) Date of filing: **06.07.84**

(51) Int. Cl.⁵: **B 08 B 7/04,** G 03 F 1/00

(54) **Automatic mask washing apparatus.**

(30) Priority: **06.07.83 JP 122706/83**

(43) Date of publication of application:
**16.01.85 Bulletin 85/03**

(45) Publication of the grant of the patent:
**09.05.90 Bulletin 90/19**

(84) Designated Contracting States:
**DE FR GB**

(56) References cited:
**JP-A-57 079 619**
**US-A-4 132 235**

(73) Proprietor: **FUJITSU LIMITED**
**1015, Kamikodanaka Nakahara-ku**
**Kawasaki-shi Kanagawa 211 (JP)**

(72) Inventor: **Yoshizawa, Takeshi c/o FUJITSU**
**LIMITED**
**Patent Department 1015 Kamikodanaka**
**Nakahara-ku**
**Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

This invention relates to an automatic mask (reticle) washing apparatus for a mask used in the production of semiconductor integrated circuits (ICs) according to the preamble of claim 1 and a method of cleaning an integrated circuit mask according to the preamble of claim 9.

In semiconductor device manufacturing, it is important to obtain clean mask surfaces in order to attain high reliability of the devices and high yield of production. Conventionally, apparatus is used to clean slices or substrates of semiconductors, but mask cleaning is done by hand. The reason for this is mainly that the number of masks used in the manufacturing process is much smaller than that of the slices. But as the scale of production increases and the complexity of ICs is increased, the number of masks used in IC manufacturing becomes large.

Contamination or damage of a mask results from dust, mist, fingermarks, spit and so forth. In order to remove such contamination, a large amount of hard washing is not desirable. Moreover the use of a strong oxidizing or alkaline agent is undesirable, because of the risk of staining the mask surface. The cleaning of masks by hand has a considerable effect. Apparatus for washing, drying of masks is beginning to be used.

From the experience of the inventor it is insufficient to use separate apparatuses for washing, drying and so on. This is because during transfer between different apparatuses, the mask surface is exposed to the air, and contaminated. It is desirable, therefore, to use a single apparatus which handles the mask automatically from loading the mask, through washing, drying to removal.

JP—A—57 079 619 discloses a mask cleansing device enabling automatic cleansing, rinsing and drying of a pattern mask. The mask is housed in a holder and moved in various directions for performing various cleansing functions on it, including washing with a water jet, washing brush, and a water brush, and drying with an air knife.

According to one aspect of the present invention, there is provided a mask washing apparatus, for cleaning a mask for use in manufacture of semiconductor devices, comprising:

a chamber having therein a mask washing room and a mask drying room;

means for loading a mask into the chamber and for removal of the mask from the chamber; and

transfer means for moving the mask within the chamber; characterised in that:

said chamber is airtight;

means are provided for providing an air stream within the chamber in a direction from the drying room to the washing room when the apparatus is in use; and in that

said drying room includes gas jet type drying means, comprising a nozzle body having a nozzle cavity which is connected at one end to a gas pipe and open at the other end, the nozzle body being cut diagonally across at the other end of the nozzle cavity, and a cover plate fixed to the diagonally cut end of the nozzle body so as to define an orifice between the cover plate and the nozzle body operable to provide an air-knife shaped jet stream of gas directed aslant of a surface of the mask when positioned for drying, said jet stream having a width greater than the width of the mask.

According to another aspect of the present invention, there is provided a method of cleaning an integrated circuit mask, comprising steps of inserting the mask in a chamber, washing the mask using a liquid, and drying the mask using drying means; characterized in that:

the chamber is made airtight;

said washing step comprises cleaning both sides of the mask by first scrubbing means, comprising scrubbing pads supplied with a cleansing substance, washing both sides of the mask by second scrubbing means, comprising scrubbing pads supplied with a liquid, and washing the mask by jets of liquid;

in that said drying step comprises blowing a gas onto both sides of the mask using a nozzle body having a nozzle cavity which is connected at one end to a gas pipe and open at the other end, the nozzle body being cut diagonally across at the other end of the nozzle cavity, and a cover plate fixed to the diagonally cut end of the nozzle body so as to define an orifice between the cover plate and the nozzle body operable to provide an air-knife shaped jet stream of gas directed aslant of a surface of the mask when positioned for drying, said jet stream having a width greater than the width of the mask;

and comprising further steps of: removing material dislodged from the mask by said drying means, by air flow means, comprising air inlets supplying outside air to micro air filter means and to air blower means, arranged to produce air flows over both sides of the mask; and removing waste liquid, cleansing substance, air and gas by draining means and exhaust means.

An embodiment of the present invention can provide a washing apparatus for a mask (reticle) in semiconductor device production which can completely automate mask loading and washing to produce a high quality mask.

An embodiment of the present invention can also provide a washing apparatus which prevents the transportation of the mask.

In an embodiment of the present invention, there is provided a specifically designed chamber. The mask is loaded into the top of the chamber and transported to the bottom of the chamber. During this time, the mask is washed and scrubbed in a cleanser, rinsed by pure water jets and dried by clean air jets.

Reference is made, by way of example to the accompanying drawings in which:—

Fig. 1 is a schematic cross-sectional view of a mask washing apparatus embodying the present invention,

Fig 2 is a front elevation perspective view of a mask holder or use with the apparatus of Fig 1,

Fig. 3 shows schematically a prior art means for drying a mask by a jet of gas,

Fig. 4(A) is a top view of a means employed in an embodiment of the invention for emitting a jet of gas to dry a mask,

Fig. 4(B) is a sectional view along the line A—A of Fig. 4(A),

Fig. 5(A) illustrates schematically a gas flow when washing apparatus embodying the invention is in a washing cycle, and

Fig. 5(B) illustrates schematically a gas flow when washing apparatus embodying the invention is in a drying cycle.

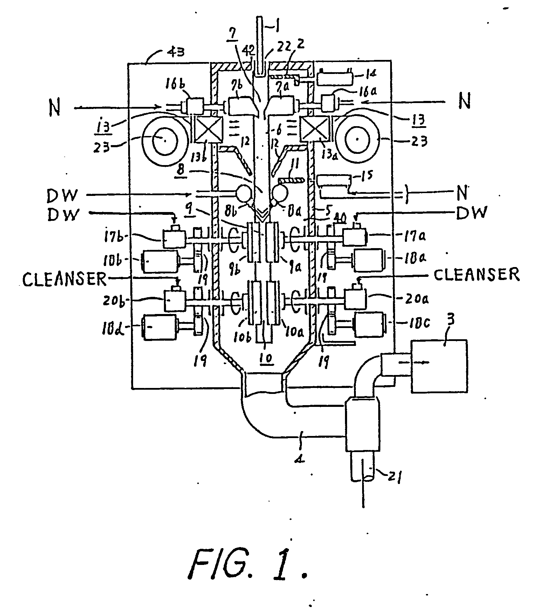

Fig. 1 shows a schematic cross sectional view of a mask washing apparatus embodying the present invention. The main part of the mask washing apparatus 43 is an airtight chamber 5, which includes a mask loading gate 42, a washing room 40 and a drying room 7.

At the top of the chamber 5 there is provided a first automatic shutter 2 which is controlled by a gas cylinder 14. The shutter 2 is opened only when a mask 1 is loaded or unloaded.

The drying room 7 in the airtight chamber 5 is provided with a pair of nozzles 7a and 7b for emitting jets of gases onto the surfaces of a mask. The mask is mounted on a mask transfer mechanism 6, and can be moved up and down in the airtight chamber 5. At the side of the airtight chamber 5, are provided a pair of air inlets 13 which are respectively connected through ducting to blowers 23. The air taken into the airtight chamber 5 is filtered by micro air filters 13a and 13b.

The washing room 40 in the airtight chamber 5 is provided with a pair of jet nozzles 8a and 8b and two pairs of scrubbing pads 9a, 9b and 10a, 10b. The nozzles 8a and 8b issue jets of distilled water (DW) to clean the mask. Each pad 9a, 9b, 10a, 10b is rotated around an axis driven by motors 18a, 18b, 18c and 18d respectively, through a transmission 19. The airtight chamber 5 is provided with means 20a and 20b for supplying cleanser to the pads 10a, 10b and means 17a, 17b for supplying water to the pads 9a, 9b.

Between the drying room 7 and the washing room 40 is arranged a separation wall 12 having a second shutter 11 which is controlled by a gas cylinder 15.

On the bottom of the airtight chamber 5 is provided an arrangement for exhausting fluids (not shown) which comprises an exhaust fan 3, an exhaust duct 4, and a drain pipe 21.

When the apparatus is in use a mask 1 is loaded on a mask holder 22, and is moved towards the bottom of the airtight chamber 5 by the mask transfer mechanism 6. After the mask 1 is inserted in the airtight chamber 5, the first shutter 2 is closed; in the same way, when the mask 1 reaches the bottom of the airtight chamber 5, the second shutter 11 is closed.

When it has reached the bottom of the airtight chamber 5, the mask 1 is positioned to face the scrubbing pads 10a and 10b in the washing room 40. In such a position the mask is washed over both surfaces by a cleanser substance. Cleanser is supplied to the scrubbing pads 10a, 10b from the cleanser suppliers 20a and 20b through pipes to which the pads are attached. During cleansing and scrubbing by the scrubbing pads 10a, and 10b, the mask is gradually lifted up towards the top of the airtight chamber 5, at a controlled speed of 3—4 (mm/sec) for example. When the mask reaches the position of the scrubbing pads 9a and 9b, it is washed by distilled water (DW). The water is supplied to the pads from water suppliers 17a and 17b through pipes to which the pads are attached. During washing by the distilled water and scrubbing by the scrubbing pads 9a and 9b, the mask is gradually lifted up as mentioned before. Similarly, when the mask has risen to the position of the pair of jet nozzles 8a and 8b, these nozzles emit jets of distilled water (DW). These jet streams blow off the water sheath covering the surfaces of the mask. Meanwhile, the mask continues to be gradually lifted up.

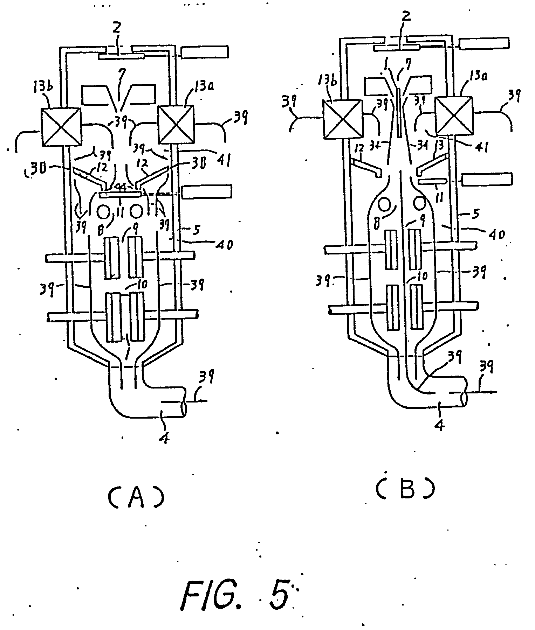

After the washing with distilled water from the jet nozzles 8a and 8b, the mask is dried in the drying room. The mask is blown by air to blow off water on the surface of the mask. Air jets blow in the direction from the upper part of the mask to the bottom of the chamber, so as to blow the water down into the bottom of the chamber without allowing water to return onto the mask. This process will be described later more clearly with regard to Fig. 5.

After the washing process in the washing room is finished, the mask is lifted up from the washing room 40 to the drying room 7 through the second shutter 11. The second shutter 11 is usually closed, but it is opened under the control of the gas cylinder 15, when the mask is required to pass through it.

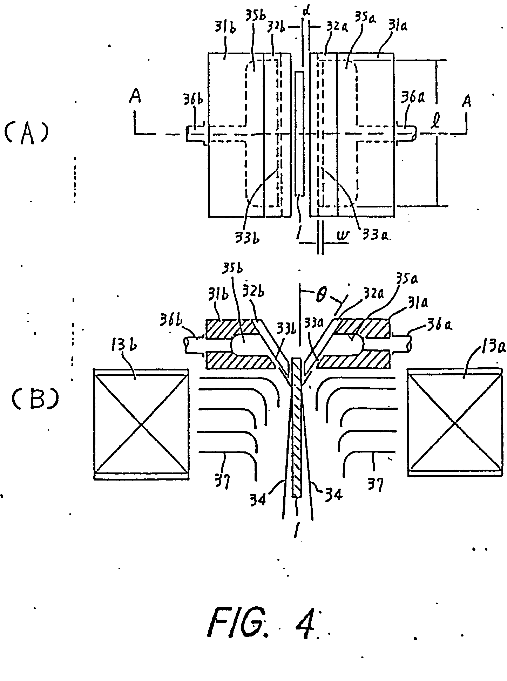

In the drying room 7, the mask is dried by a pair of air-knife shaped nozzles 7a and 7b which emit jets of dried nitrogen (N) onto the mask. The knife shaped nozzles will be described in more detail later with regard to Fig. 4. During this time the mask is also dried by air from the blowers 23 having micro filters 13a and 13b. After the drying of the mask is completed, the mask is taken out from the airtight chamber 5 through the first shutter 2.

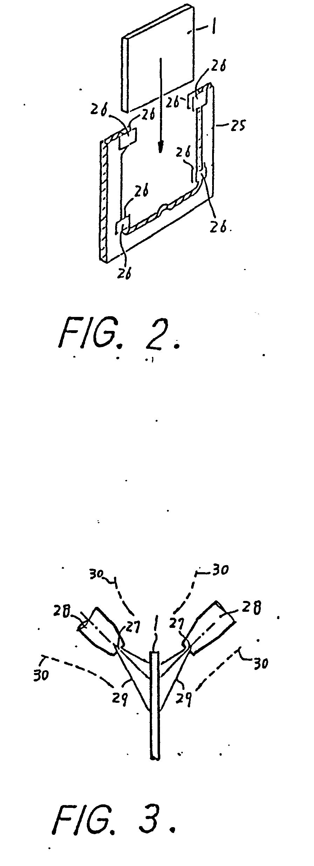

Fig. 2 is a front elevation perspective view of a portion of a mask holder 22 as illustrated in Fig. 1. The mask holder 22 comprises a frame 25, and holder springs 26 made of stainless steel for example. The size of the mask holder is chosen as appropriate for the size of the mask. The mask 1 is inserted in the mask holder as shown by the arrow and supported by the holder springs 26.

Conventionally, mask drying is achieved using a spin dryer or by means of natural drying; sometimes it is performed after water on the mask is replaced by alcohol.

In such methods, it is difficult to dry the mask speedily, moreover the mask may be contaminated during the drying process. The contamination is further increased when the mask is transported from one apparatus to a next apparatus. Moreover, conventional washing methods have other drawbacks.

For example, Fig. 3 shows schematically a known means for drying the mask by a jet of gas. The type of nozzle shown in Fig. 3 is sometimes called an air-knife nozzle. The nozzle 28 emits a knife shaped gas flow 29 diagonally onto the mask 1. The V shaped slit 27 provides a thin planar stream, the width of which is equal to the width of the mask. The gas flow from this type of nozzle spreads out as illustrated in Fig. 3, and it drags in the surrounding air as shown by broken line arrows 30. Because of the introduction into the gas flow of the surrounding air, surrounding contaminant is caught and the mask suffers contamination. The contaminant may include not only dust in the air, but also contamination which has been just removed from the mask. This spoils the cleaning effect of the washing apparatus.

In order to overcome such problems, in the drying process in an apparatus embodying the present invention, the jet nozzle is specially shaped. That is, it provides a pair of air-knife nozzles 7a and 7b, which emit gas jets onto the mask. Fig. 4(A) is a top view of means for emitting such gas jets and Fig. 4(B) is a sectional view along the line A—A of Fig. 4(A).

Tips of nozzle bodies 31a and 31b are cut aslant to the surface of the mask 1 at an angle of θ (for example 50—60 degrees), and cover plates 32a and 32b are attached to the slanting cut parts of the tips, as shown in Fig. 4(B). An orifice 33a and an orifice 33b each with a width (thickness) W between the nozzle body and a cover plate is provided as shown in Fig. 4(A). As a result, an air-knife 34 (of nitrogen gas) is formed by the orifices 33a and 33b. The gas flow of the air-knife is directed downward along the surface of the mask 1. A gap d between the mask 1 and either of the cover plates 32a and 32b is set to be less than one mm. In the nozzle bodies 31a and 31b are provided cavities 35a and 35b respectively, which are connected to gas pipes 36a and 36b respectively. The width of the resulting jet stream exceeds the width of the mask.

As shown in Fig. 4(B), there are provided micro air filters 13a and 13b close to the gas pipes 36a and 36b, which provide dust free air flows 37 towards the mask 1 Moreover, the gas in the airtight chamber 5 is evacuated by pumping from the bottom of the chamber (not shown). It will be apparent from the illustration that the problem of surrounding air being dragged into the knife-shaped air jet is completely prevented. Therefore, contamination by dragged-in air is eliminated.

Fig. 5(A) illustrates schematically gas flow in the chamber when the washing apparatus is operating in the washing cycle (process), and Fig. 5(B) illustrates schematically gas flow in the chamber when the washing apparatus is in the drying cycle (process). Reference numerals in the Figure designate corresponding parts of the apparatus to those shown in Fig. 1.

During washing of the mask 1, as shown in Fig. 5(A), the first shutter 2 is closed, outside air is taken in through the micro air filters 13a and 13b, and the pressure in the drying room is raised, so a stream of filtered air 39 flows into the washing room through a gap 38 between the separation wall 12 and the side wall of the chamber 5. At the same time, filtered air flows through a gap 44 between the separation wall 12 and the second shutter II. These air flows prevent any mist containing washing water, or contaminated air, from returning from the washing room 40 back into the drying room 7. The mist and the contaminated air in the washing room are removed by the drain and exhaust duct 4. Furthermore, these air flows prevent settling or condensation of mist on surfaces in the drying room.

During the drying cycle of the mask 1, as shown in Fig. 5(B), the first shutter 2 is closed, but the second shutter 11 is open. Outside air is introduced through the micro air filters 13a and 13b, and the resulting filtered air stream 39 flows downward into the washing room 40. A pair of air-knives 34 blow gas downwards over the mask 1, so the mask is dried speedily.

Since the mask 1 moves gradually upwards, and the air-knives 34 blow downwards from the upper portion to the lower portion of the mask 1, this prevents mist created in the drying process from settling on the dried portion of the mask.

As has been described above, by using an automatic mask washing apparatus in accordance with the present invention, it is possible to clean a mask by processing in a chamber without the use of a strong oxidizing agent or strong alkaline agent. Damage to the mask caused by dust or mist is avoided, and clean surfaces of the mask are obtained; consequently, the reliability of the mask and the production yield of IC devices are increased.

It should be noted that the preferred embodiments described herein are illustrative and not restrictive, the scope of the invention being indicated by the appended claims and all variations which come within the meaning of the claims.

**Claims**

1. A mask washing apparatus, for cleansing a mask for use in manufacture of semiconductor devices, comprising:

a chamber (5) having therein a mask washing room (40) and a mask drying room (7);

means (42) for loading a mask (1) into the chamber and for removal of the mask from the chamber; and

transfer means (6) for moving the mask within the chamber; characterised in that:

said chamber (5) is airtight;

means (13, 23) are provided for providing an air stream within the chamber in a direction from the drying room (7) to the washing room (40) when the apparatus is in use; and in that

said drying room (7) includes gas jet type drying means (7a, 7b), comprising a nozzle body (31a, 31b) having a nozzle cavity (35a, 35b) which is connected at one end to a gas pipe (36a, 36b) and open at the other end, the nozzle body being cut diagonally across at the other end of the nozzle cavity, and a cover plate (32a, 32b) fixed to the diagonally cut end of the nozzle body so as to define an orifice (33a, 33b) between the cover plate and the nozzle body operable to provide an air-knife shaped jet stream (34) of gas directed aslant of a surface of the mask (1) when positioned for drying, said jet stream (34) having a width greater than the width of the mask (1).

2. A mask washing apparatus as claimed in claim 1, wherein said loading and removal means (42) comprises a gate located at a first end of the chamber; and wherein the apparatus further comprises;

a drain and exhaust duct (4, 21) provided at a second end of the chamber, for exhausting gas and liquid from the chamber; and

a means (13) located in a first part of the chamber, for taking in air from outside the chamber;

and wherein said air stream within the chamber is operably produced during a washing process and during a drying process thereafter.

3. A mask washing apparatus as claimed in claim 2, wherein the chamber (5) is arranged vertically, with the first end uppermost, the drying room (7) is located in an upper part of the chamber, and the washing room (40) is located in a lower part of the chamber, said chamber (5) further comprising:

a first shutter (2) located at the top of the chamber, said first shutter being closed during the washing process and the drying process and being open during a loading or unloading operation of the mask (1)i and

a second shutter (11) located between the drying room and the washing room, said second shutter being closed during the washing process, and being open during the drying process.

4. A mask washing apparatus as claimed in claim 2 or 3, wherein said means (13) for taking in air comprise a micro air filter (13a, 13b) which filters the air from outside the chamber.

5. A mask washing apparatus as claimed in claim 2, 3 or 4, further comprising an exhaust fan (3) connected to the drain and exhaust duct (4).

6. A mask washing apparatus as claimed in claim 2, 3, 4 or 5, wherein said gate (42) is located at the top of the drying room (7), said drying means (7a, 7b) is located below the gate, and said means (13) for taking in air is located below the drying means.

7. A mask washing apparatus as claimed in any preceding claim, wherein said washing room (40) contains washing means comprising:

jet washing means (8a, 8b) for emitting a jet stream of distilled water onto both sides of the mask (1);

scrub washing means (9a, 9b) for scrubbing both sides of the mask; and

cleansing means (10a, 10b) for washing both sides of the mask with a cleansing substance.

8. A mask washing apparatus as claimed in claim 3 or any of claims 4 to 7 as appended thereto, wherein said transfer means (6) is movable between the top and the bottom of the chamber (5).

9. A method of cleaning an integrated circuit mask, comprising steps of inserting the mask (1) in a chamber (5), washing the mask using a liquid, and drying the mask using drying means (7a, 7b); characterised in that:

the chamber (5) is made airtight;

said washing step comprises cleaning both sides of the mask (1) by first scrubbing means (10a, 10b), comprising scrubbing pads supplied with a cleansing substance, washing both sides of the mask by second scrubbing means (9a, 9b), comprising scrubbing pads supplied with a liquid, and washing the mask by jets of liquid (8a, 8b);

in that said drying step comprises blowing a gas onto both sides of the mask using a nozzle body having a nozzle cavity which is connected at one end to a gas pipe and open at the other end, the nozzle body (31a, 31b) having a nozzle cavity (35a, 35b) which is connected at one end to a gas pipe (36a, 36b) and open at the other end, the nozzle body being cut diagonally across at the other end of the nozzle cavity, and a cover plate (32a, 32b) fixed to the diagonally cut end of the nozzle body so as to define an orifice (33a, 33b) between the cover plate and the nozzle body operable to provide an air-knife shaped jet stream (34) of gas directed aslant of a surface of the mask (1) when positioned for drying, said jet stream (34) having a width greater than the width of the mask (1);

and comprising further steps of: removing material dislodged from the mask (1) by said drying means (7a, 7b), by air flow means, comprising air inlets (13) supplying outside air to micro air filter means (13a, 13b) and to air blower means (23), arranged to produce air flows over both sides of the mask; and removing waste liquid, cleansing substance, air and gas by draining means and exhaust means (4, 21).

**Patentansprüche**

1. Maskenwaschvorrichtung, zur Reinigung einer Maske zur Verwendung bei der Herstellung von Halbleitervorrichtungen, mit:

einer Kammer (5), welche einen Maskenwaschraum (40) und einen Maskentrockenraum (7) umfaßt;

Einrichtungen (42) zum Laden einer Maske (1) in die Kammer und zur Entfernung der Maske aus der Kammer; und

Transfereinrichtungen (6) zur Bewegung der Maske innerhalb der Kammer, dadurch gekennzeichnet, daß:

die genannte Kammer (5) luftdicht ist;

Einrichtungen (13, 23) vorgesehen sind, um einen Luftstrom innerhalb der Kammer in einer Richtung von dem Trockenraum (7) zu dem Waschraum (40) zu liefern, wenn die Vorrichtung in Benutzung ist, und daß

der genannte Trockenraum (7) Gasstromtyp-Trockeneinrichtungen (7a, 7b) enthält, die einen Düsenkörper (31a, 31b) umfassen, der einen Düsenhohlraum (35a, 35b) hat, der an einem Ende mit einem Gasrohr (36a, 36b) verbunden und an seinem anderen Ende offen ist, welcher Düsenkörper an dem anderen Ende des Düsenhohlraums diagonal quer geschnitten ist, und eine Deckplatte (32a, 32b), die an dem diagonal geschnittenen Ende des Düsenkörpers so befestigt ist, daß sie eine Öffnung (33a, 33b) zwischen der Deckplatte und dem Düsenkörper definiert, die betreibbar ist, um einen luftmesserförmigen Düsenstrom (34) von Gas zu liefern, der schräg zur Oberfläche der Maske (1) gerichtet ist, wenn er für die Trocknung positioniert ist, wobei der genannte Düsenstrom (34) eine Breite hat, die größer als die Breite der Maske (1) ist.

2. Maskenwaschvorrichtung nach Anspruch 1, bei der die genannte Lade und Entfernungseinrichtung (42) ein Tor hat, welches an einem ersten Ende der Kammer angeordnet ist, und bei der die Vorrichtung ferner umfaßt;

einen Ablaß- und Ausstoßkanal (4, 21), der an einem zweiten Ende der Kammer vorgesehen ist, um Gas und Flüssigkeit aus der Kammer zu entfernen; und

eine Einrichtung (13), die in einem ersten Teil der Kammer vorgesehen ist, um Luft von der Außenseite in die Kammer hereinzunehmen;

und bei der der genannte Luftstrom während eines Waschprozesses und während eines folgenden Trocknungsprozesses innerhalb der Kammer erzeugt wird.

3. Maskenwaschvorrichtung nach Anspruch 2, bei der die Kammer (5) vertikal angeordnet ist, mit dem ersten Ende zu oberst, der Trockenraum (7) in einem oberen Teil der Kammer angeordnet ist und der Waschraum (40) in einem unteren Teil der Kammer angeordnet ist, und die Kammer (5) ferner umfaßt:

einen ersten Verschluß (2), der an der Oberseite der Kammer angeordnet ist, welcher genannte erste Verschluß während des Waschprozesses und des Trocknungsprozesses geschlossen ist und während des Ladeund Entladebetriebs der Maske (1) geöffnet ist; und

einen zweiten Verschluß (11), der zwischen dem Trockenraum und dem Waschraum angeordnet ist, welcher zweite Verschluß während des Waschprozesses geschlossen und während des Trockenprozesses geöffnet ist.

4. Maskenwaschvorrichtung nach Anspruch 2 oder 3, bei der die genannte Einrichtung (13) zur Einnahme der Luft einen Mikroluftfilter (13a, 13b) umfaßt, der die Luft von außerhalb der Kammer filtert.

5. Maskenwaschvorrichtung nach Anspruch 2, 3 oder 4, ferner mit einem Lüfterventilator (3), der mit dem Ablaß- und Ausstoßkanal (4) verbunden ist.

6. Maskenwaschvorrichtung nach Anspruch 2, 3, 4 oder 5, bei der das genannte Tor (42) an der Oberseite des Trockenraumes (7) angeordnet ist, die genannte Trockeneinrichtung (7a, 7b) unterhalb des Tors angeordnet ist und die genannte Einrichtung (13) zur Einnahme von Luft unterhalb der Trockeneinrichtung angeordnet ist.

7. Maskenwaschvorrichtung nach einem der vorhergehenden Ansprüche, bei der der genannte Waschraum (40) Wascheinrichtungen enthält, welche umfassen:

Düsenwascheinrichtungen (8a, 8b) zum Emittieren eines Düsenstromes aus destilliertem Wasser auf beide Seiten der Maske (1);

Scheuerwascheinrichtungen (9a, 9b) zum Scheuern beider Seiten der Maske; und

Reinigungseinrichtungen (10a, 10b) zum Waschen beider Seiten der Maske mit einer Reinigungssubstanz.

8. Maskenwaschvorrichtung nach Anspruch 3 oder einem der Ansprüche 4 bis 7 in Verbindung damit, bei der die genannte Transfereinrichtung (6) zwischen der Oberseite und dem Boden der Kammer (5) bewegbar ist.

9. Verfahren zum Reinigen einer integrierten Schaltungsmaske mit den Schritten der Einführung der Maske (1) in eine Kammer (5), Waschen der Maske unter Verwendung einer Flüssigkeit und Trocknen der Maske unter Verwendung von Trockeneinrichtungen (7a, 7b); dadurch gekennzeichnet, daß

die Kammer (5) luftdicht ist;

der genannte Waschschritt das Reinigen beider Seiten der Maske (1) durch eine erste Scheuereinrichtung (10a, 10b) umfaßt, welche Scheuerbäusche umfaßt, denen eine Reinigungssubstanz zugeführt wird, Waschen beider Seiten der Maske durch eine zweite Scheuereinrichtung (9a, 9b), welche Scheuerbäusche umfaßt, denen eine Flüssigkeit zugeführt wird, und Waschen der Maske durch Flüssigkeitsströme (8a, 8b);

der genannte Trockungsschritt das Blasen eines Gases auf beide Seiten der Maske unter Verwendung eines Düsenkörpers umfaßt, der einen Düsenhohlraum hat, welcher an einem Ende mit einem Gasrohr verbunden und an seinem anderen Ende offen ist, wobei der Düsenkörper (31a, 31b) einen Düsenhohlraum (35a, 35b) hat, der an einem Ende mit einem Gasrohr (36a, 36b) verbunden und an dem anderen Ende offen ist, der Düsenkörper an dem anderen Ende des Düsenhohlraumes diagonal quer geschnitten ist und eine Deckplatte (32a, 32b) an dem diagonal geschnittenen Ende des Düsenkörpers befestigt ist, um so eine Öffnung (33a, 33b) zwischen der Deckplatte und dem Düsenkörper zu definieren, welche betreibbar ist, um einen luftmesserförmigen Strahlungsstrom (34) aus Gas schräg auf eine Oberfläche der Maske (1) zu liefern, wenn er zum Trocknen positioniert ist, welcher genannte Düsenstrom (34) eine Breite hat, die größer als die Breite der Maske (1) ist;

und ferner mit den folgenden Schritten: Entfernen von Material, welches von der Maske (1) durch die genannte Trockeneinrichtung (7a, 7b) entfernt wurde, durch Luftstromeinrichtungen, welche Lufteinlässe (13) umfassen, die Außenluft zu einer Mikroluftfiltereinrichtung (13a, 13b) und zu einer Luftblaseinrichtung (23) liefern, welche angeordnet ist, um Luftströme über beide Seiten der Maske zu erzeugen; und Entfernen von Abfallflüssigkeit, Reinigungssubstanz, Luft und Gas durch Ablaß- und Auspuffeinrichtungen (4, 21).

## Revendications

1. Appareil de lavage de masque, destiné à nettoyer un masque utilisé pour la fabrication de dispositifs à semiconducteur, comprenant

une chambre (5) qui contient un espace de lavage (40) et un espace de séchage (7) de masque,

un dispositif (42) de chargement d'un masque (1) dans la chambre et d'extraction du masque de la chambre, et

un dispositif de transfert (6) destiné à déplacer le masque dans la chambre, caractérisé en ce que

la chambre (5) est hermétique,

un dispositif (13, 23) est destiné à former un courant d'air à l'intérieur de la chambre, de l'espace de séchage (7) vers l'espace de lavage (40) lorsque l'appareil est en cours d'utilisation, et en ce que

l'espace de séchage (7) comporte un dispositif de séchage du type à projection de gaz (7a, 7b), comportant un corps de buse (31a, 31b) ayant une cavité de buse (35a, 35b) qui est connectée, à une première extrémité, à une tuyauterie de gaz (36a, 36b) et qui est ouverte à l'autre extrémité, le corps de buse étant coupé en diagonale transversalement à l'autre extrémité de la cavité de la buse, et une plaque formant couvercle (32a, 32b) fixée à l'extrémité du corps de buse qui est coupée en diagonale afin qu'un orifice (33a, 33b) soit délimité entre la plaque formant couvercle et le corps de buse et forme un courant (34) de gaz en forme de rideau d'air dirigé en direction inclinée par rapport à la surface du masque (1) lorsque celui-ci est en position de séchage, le courant projeté (34) ayant une largeur supérieure à celle du masque (1).

2. Appareil de lavage de masque selon la revendication 1, dans lequel les dispositifs de chargement et d'extraction (42) comportent une porte placée à une première extrémité de la chambre, et l'appareil comporte en outre

un conduit (4, 21) de purge et d'échappement placé à une seconde extrémité de la chambre et destiné à évacuer le gaz et le liquide de la chambre, et

un dispositif (13) placé dans une première partie de la chambre et destiné à introduire de l'air de l'extérieur de la chambre, et

le courant d'air formé dans la chambre est produit lors de l'opération de lavage et lors de l'opération ultérieure de séchage.

3. Appareil de lavage de masque selon la revendication 2, dans lequel la chambre (5) est disposée verticalement, avec sa première extrémité à la partie supérieure, l'espace de séchage (7) est placé dans une partie supérieure de la chambre, et l'espace de lavage (40) est placé dans une partie inférieure de la chambre, la chambre (5) comportant en outre:

un premier obturateur (2) placé à la partie supérieure de la chambre, ce premier obturateur étant fermé pendant l'opération de lavage et l'opération de séchage et étant ouvert pendant l'opération de chargement ou de déchargement du masque (1), et

un second obturateur (11) placé entre l'espace de séchage et l'espace de lavage, le second obturateur étant fermé pendant l'opération de lavage et étant ouvert pendant l'opération de séchage.

4. Appareil de lavage de masque selon la revendication 2 ou 3, dans lequel le dispositif (13) d'introduction d'air comporte des microfiltres à air (13a, 13b) qui filtrent l'air provenant de l'extérieur de la chambre.

5. Appareil de lavage de masque selon la revendication 2, 3 ou 4, comprenant en outre un ventilateur d'échappement (3) raccordé au conduit de purge et d'échappement (4).

6. Appareil de lavage de masque selon la revendication 2, 3, 4 ou 5, dans lequel la porte (42) est placée à la partie supérieure de l'espace de séchage (7), le dispositif de séchage (7a, 7b) est placé sous la porte, et le dispositif (13) d'introduction d'air est placé sous le dispositif de séchage.

7. Appareil de lavage de masque selon l'une quelconque des revendications précédentes, dans lequel l'espace de lavage (40) contient un dispositif de lavage qui comporte

un dispositif (8a, 8b) de lavage par projection qui émet un courant d'eau distillée sur les deux faces du masque (1),

un dispositif (9a, 9b) de lavage destiné à récurer les deux côtés du masque, et

un dispositif de nettoyage (10a, 10b) destiné à laver les deux faces du masque à l'aide d'une substance de nettoyage.

8. Appareil de lavage de masque selon la revendication 3 ou l'une quelconque des revendications 4 à 7 lorsqu'elle dépend de la revendication 3, dans lequel le dispositif de transfert (6) est mobile entre la partie supérieure et la partie inférieure de la chambre (5).

9. Procédé de nettoyage d'un masque pour circuit intégré, comprenant les étapes d'introduction du masque (1) dans une chambre (5), de lavage du masque avec un liquide, et de séchage du masque à l'aide d'un dispositif de séchage (7a, 7b), caractérisé en ce que

la chambre (5) est hermétique,

l'étape de lavage comporte le nettoyage des deux faces du masque (1) par un premier dispositif de récurage (10a, 10b), comprenant des tampons de récurage recevant une substance de nettoyage, le lavage des deux faces du masque par un second dispositif de récurage (9a, 9b) comprenant des tampons de récurage recevant un liquide, et le lavage du masque par des jets de liquide (8a, 8b), et en ce que

l'étape de séchage comprend le soufflage d'un gaz sur les deux faces du masque à l'aide d'un corps de buse ayant une cavité de buse qui est raccordée, à une première extrémité, à une tuyauterie de gaz et qui est ouverte à l'autre extrémité, le

corps de buse (31a, 31b) ayant une cavité de buse (35a, 35b) qui est connectée à une première extrémité à une tuyauterie de gaz (36a, 36b) et qui est ouverte à l'autre extrémité, le corps de buse étant coupé en diagonale transversalement à l'autre extrémité de la cavité de la buse, et une plaque formant couvercle (32a, 32b) est fixée à l'extrémité du corps de buse qui est découpée en diagonale afin qu'un orifice (33a, 33b) soit délimité entre la plaque formant couvercle et le corps de buse et forme un courant de gaz (34) en forme de rideau d'air dirigé en direction inclinée sur une surface du masque (1) lorsque celui-ci est en position de séchage, le courant projeté (34) ayant une largeur supérieure à la largeur du masque (1), et

il comporte en outre les étapes d'extraction de la matière délogée du masque (1) par le dispositif de séchage (7a, 7b), à l'aide d'un dispositif de circulation d'air comprenant des entrées d'air (13) transmettant l'air externe à des microfiltres (13a, 13b) d'air et à un dispositif (23) à ventilateur destiné à transmettre des courants d'air sur les deux faces du masque, et l'extraction du liquide usé, de la substance de nettoyage, de l'air et du gaz par un dispositif de purge et un dispositif d'échappement (4, 21).

FIG. 1.

FIG. 2.

FIG. 3.

FIG. 4.

(A)

(B)

FIG. 5